# EUROPÄISCHE PATENTSCHRIFT

(11) **EP 3 966 577 B1**
(45) Veröffentlichungstag und Bekanntmachung des Hinweises auf die Patenterteilung: **19.07.2023**
(21) Anmeldenummer: 20724801.4
(22) Anmeldetag: 07.05.2020
(51) Int. Cl.: G01R 29/08, G01R 15/20, G01R 19/165, G01R 15/14, H02G 13/00, G01R 1/18

(54) **VORRICHTUNG ZUR ERFASSUNG ELEKTRISCHER STRÖME AN ODER IN DER NÄHE ELEKTRISCHER LEITER**
DEVICE FOR DETECTING ELECTRICAL CURRENTS ON OR IN THE VICINITY OF ELECTRICAL CONDUCTORS
DISPOSITIF DE DÉTECTION DE COURANTS ÉLECTRIQUES AU NIVEAU OU À PROXIMITÉ DE CONDUCTEURS ÉLECTRIQUES

(30) Priorität: 08.05.2019 DE 102019112032
(43) Veröffentlichungstag der Anmeldung: 16.03.2022
(73) Patentinhaber: DEHN SE, 92318 Neumarkt i.d. OPf. (DE)
(72) Erfinder: EHRHARDT, Arnd, 92318 Neumarkt (DE); BÜHLER, Klaus, 90542 Eckental (DE); SCHWANDNER, Torsten, 90475 Nürnberg (DE); HIERETH, Nicole, 92283 Lauterhofen (DE)
(74) Vertreter: Prinz & Partner mbB
(86) Internationale Anmeldenummer: PCT/EP2020/062649
(87) Internationale Veröffentlichungsnummer: WO 2020/225337

(56) Entgegenhaltungen:
- WO-A1-2019/185172
- DE-A1- 19 733 268
- DE-A1-102018 107 475
- US-A- 3 720 894

## Beschreibung

Die Erfindung betrifft eine Vorrichtung zur Erfassung elektrischer Ströme an oder in der Nähe elektrischer Leiter, welche Bestandteil einer Blitzstromableitung, einer Fangstange oder dergleichen Einrichtung sind, mit mehreren Reed-Kontakten als magnetisch ansprechenden Schaltern, welche so in der Nähe des elektrischen Leiters angeordnet sind, dass bei einem signifikanten Stromfluss durch den Leiter das resultierende magnetische Feld den Schalter auslöst, wobei für eine Detektion von Stoßstromgrößen und Unterscheidung von Langzeitimpulsströmen und Kurzzeitimpulsströmen eine Vielzahl von Reed-Kontakten in vorgegebenen, unterschiedlichen Abstand vom Leiter angeordnet sind, weiterhin mit einer Auswerteelektronik mit Mikrocontroller, die das Ansprechen und die Schaltzeiten der jeweiligen Reed-Kontakte ermittelt und eine Wertezuordnung vornimmt, gemäß Patentanspruch 1.

Aus der DE 10 2018 107 475 A1 ist eine Vorrichtung zur Erfassung elektrischer Ströme an oder in der Nähe elektrischer Leiter vorbekannt.

Diese Vorrichtung geht auf mindestens einen Reed-Kontakt zurück, welcher als magnetisch ansprechender Schalter ausgebildet und der so in der Nähe eines elektrischen Leiters angeordnet ist, dass bei einem signifikanten Stromfluss durch den Leiter das entstehende magnetische Feld den Schalter auslöst und eine mit dem Schalter in Verbindung stehende Auswerteelektronik anstößt.

Die vorbekannte Lösung geht von der Aufgabe aus, nicht nur einen Schaltzustand mit Erreichen eines bestimmten Stromflusses im elektrischen Leiter zu definieren, sondern ebenso die Möglichkeit zu schaffen, Stromimpulse und damit Stoßströme zu ermitteln und diese auszuwerten.

Diesbezüglich wird von einer quasi räumlich gestaffelten, bezogen auf einen elektrischen Leiter beabstandeten und/oder in ihrer Empfindlichkeit gestaffelten Anordnung von mehreren Reed-Kontakten ausgegangen, die zur Ermittlung von Stoßstromgrößen herangezogen werden. Dabei sollen nicht nur Langzeitimpulsströme erkennbar, sondern auch Kurzzeitimpulsströme bewertet werden können.

Die bekannte Vorrichtung zur Erfassung elektrischer Ströme unter Nutzung von Reed-Kontakten kann in eine Fangstange integriert werden oder Bestandteil einer solchen Fangstange sein, um Blitzereignisse zu bewerten.

Die Reed-Kontakte können auch an bzw. in der Nähe elektrisch leitfähiger Bauteile installiert werden, die prinzipiell nicht für den Blitzschutz vorgesehen sind, über die aber ein Blitzteilstrom fließen kann. Hier wird beispielsweise auf Förderseile von Seilbahnen, Halteseile von Kränen oder dergleichen verwiesen.

Die bekannte Lösung ermöglicht bei ihrer Anwendung das Erreichen einer Doppelfunktion, indem Störstromimpulse, zum Beispiel auf der Basis von Blitzereignissen, erfasst werden und diese hinsichtlich der Impulsform und Impulsdauer, aber auch der Stromhöhe unterscheidbar sind.

Die erwähnte Auswerteelektronik ermittelt das Ansprechen und die Schaltzeiten der jeweiligen Reed-Kontakte. Aus der Zuordnung der ermittelten Werte zu dem Reed-Kontakt, respektive dessen räumliche Anordnung und dem Abstand zum elektrischen Leiter, lässt sich die Stoßstromgröße und aus der Schaltzeit die Impulsform, bevorzugt unter Einsatz eines Mikrocontrollers ermitteln oder bestimmen.

Die DE 197 33 268 A1 beschreibt ein Verfahren zum Detektieren von Über- und Kurzschlussströmen in Leitern einer Mittel- oder Hochspannungsanlage sowie eine Einrichtung zum Durchführen des Verfahrens. Die Einrichtung verfügt über je einen Reed-Kontakt pro Leiter der Anlage, welche bei Auftreten eines durch einen Über- oder Kurzschlussstrom erzeugten Magnetfelds auslösen und auf diese Weise einen Impuls in der Einrichtung erzeugen. Jeder der Reed-Kontakte ist mit Auswerteeinheiten verbunden, welche die Impulsbreite und/oder die Impulszahl erfassen und bei Erreichen eines Schwellenwerts eine Unterbrechung erzeugen.

Aus der US 3 720 894 A ist eine Stromüberwachungsvorrichtung bekannt, welche einen Reed-Schalter sowie eine Schirmung vorsieht. Der Reed-Schalter überwacht eine von Gleichstrom durchflossene Sammelschiene, wobei der Strom, bei welchem der Reed-Schalter auslöst, über die Ausrichtung des Reed-Schalters einstellbar ist.

Die DE 10 2018 107 475 A1 offenbart auch die Schirmung der Reed-Kontakte zur Einstellung von Grenzen des Ansprechverhaltens. Die Schirmung kann als metallische Hülse oder metallische Schicht ausgeführt werden.

Es hat sich jedoch gezeigt, dass bei einer Lösung gemäß DE 10 2018 107 475 A1 eine Unterscheidung des Energieinhaltes, das heißt des I²t-Wertes, von Impulsen bisher nicht möglich ist.

Bei einer raschen Impulsabfolge, wie sie bei einem üblichen Blitzereignis auftritt, können aufgrund der mechanischen Trägheit der Sensoren und dem damit verbundenen Schließen erst deutlich nach der Impulsbelastung die einzelnen Entladungen nicht exakt erfasst werden. Vielmehr kommt es bei einer Abfolge von Entladungen zu einer wiederholten Anregung des Kontaktes, gegebenenfalls bereits während seiner Bewegung. Somit wird unter Umständen nur die stärkste Entladung eines Blitzereignisses erfasst. Da diese Entladung jedoch nicht mit der Erstanregung erfolgen muss, ist auch ein Zeitbezug kaum möglich, da auch die Schließzeit derartiger Reed-Kontakte im Wesentlichen durch das mechanische Verhalten und nicht durch den Impuls selber bestimmt wird. Durch die starke unterschiedliche Amplitude, welche bei verschiedenen Impulsformen den jeweiligen Sensor aktiviert, ist auch keine direkte Messung des Magnetfeldes eines Stromes gegeben. Auf den auslösenden Strom muss somit aus der Kenntnis des mechanischen Verhaltens des Sensors bei verschiedenen Impulsformeln zurückgeschlossen werden.

Es bietet also die DE 10 2018 107 475 A1 keinen Ansatz für die Erfassung und Bewertung des einzelnen Impulses eines Blitzereignisses, die Erfassung und Bewertung von Impulsen, welche einem Langzeitstrom überlagert sind und ebenso wenig einen Ansatz zur Unterscheidung des Energieinhaltes, das heißt des I²t-Wertes, von Impulsen gleicher Amplitude während eines kompletten Blitzereignisses.

Aus dem Vorgenannten ist es daher Aufgabe der Erfindung, eine weiterentwickelte Vorrichtung sowie ein Verfahren zur Erfassung elektrischer Ströme an oder in der Nähe elektrischer Leiter anzugeben, welche bzw. welches eine Blitzentladung mit einer hinreichenden Genauigkeit bezüglich der Anzahl, der Höhe und dem Energieinhalt der einzelnen Entladung bestimmen kann. Darüber hinaus soll die zu schaffende Vorrichtung möglichst einfach an unterschiedlichen Teilen einer Blitzstromfang- bzw. Ableitvorrichtung installierbar sein.

Die Lösung der Aufgabe der Erfindung erfolgt vorrichtungsseitig gemäß der Merkmalskombination nach Anspruch 1 sowie mit einem Verfahren gemäß Anspruch 4, wobei die jeweiligen Unteransprüche mindestens zweckmäßige Ausgestaltungen und Weiterbildungen der Erfindungsidee umfassen.

Um Einzelimpulse eines Blitzereignisses erfassen und bewerten zu können, sind ein unmittelbarer Bezug zwischen der Höhe des Magnetfeldes eines Stromes und dem Ansprechen eines Sensors sowie ein sehr genauer Zeitbezug zum Impulsanfang und Impulsende neben einer geeigneten Auswertung über den gesamten relevanten Strombereich beispielsweise von 100 A bis 100 kA notwendig. Darüber hinaus ist es sinnvoll, dass auch bei höheren Werten beispielsweise bis 200 kA das Messsystem nicht geschädigt wird.

Reed-Kontakte besitzen ferromagnetisches Material, welches in magnetischen Feldern bestimmter Höhe gesättigt wird, wodurch die Fähigkeit des Kontaktes sich zu schließen unterbunden wird. Hierdurch ist kein Zeitbezug zum Impulsbeginn oder zur Impulsdauer mehr möglich. Dieser Effekt tritt insbesondere bei Sensoren mit hoher Empfindlichkeit bereits bei Strömen von nur einigen Kiloampere auf. Diese Sensoren besitzen jedoch den Vorteil, dass nicht nur sehr kleine Ströme von nur wenigen 10 A detektiert werden können, sondern sie besitzen auch eine sehr geringe und reproduzierbare Reaktionszeit, wodurch auch bei sehr steilen und kurzen Impulsen ein Schließen während des Impulses selbst möglich ist. Ebenso ist die Öffnungsverzugszeit beim Unterschreiten des Magnetfeldes eines sinkenden Stromes recht gering, so dass das Schließen und Öffnen bei kleinen Strömen einen direkten Bezug zur Impulsdauer und zur Stromhöhe liefert. Bei sehr hohen Strömen kommt es neben der Sättigung jedoch auch zu einer starken mechanischen Anregung, wodurch die Kontakte zum Prellen bzw. auch zum Schließverzug neigen. Diese beiden Effekte führen dazu, dass weder das Ansprechen noch die Schließzeit der Kontakte bei hohen Magnetfeldern bzw. Strömen bzgl. der Stromamplitude noch der Impulsdauer auswertbar sind.

Die Möglichkeit der räumlichen Anordnung scheidet bei hohen Strömen von mehreren 10 kA aufgrund der benötigten Distanzen aus. Der Einsatz von unempfindlichen Sensoren scheidet aufgrund des mechanischen Verzuges aufgrund des fehlenden Zeitbezuges und dem bei Impulsen nur indirekt gegebenen Bezug zur Stromhöhe für die Aufgabenstellung aus.

Eine ferromagnetische Schirmung der Reed-Kontakte kann die Empfindlichkeit verändern, jedoch ist hierzu erst die Sättigung des Schirmmaterials erforderlich. Dies führt dazu, dass der Bezug zum Impulsbeginn sich auch zeitlich verschiebt. Eine solche Verschiebung ist nur vernachlässigbar, wenn die Höhe des Magnetfeldes deutlich über der Grenze der Abschirmung liegt und die Eigenempfindlichkeit des Reed-Kontaktes deutlich unterhalb der Abschirmwirkung der Schirmung liegt.

Darüber hinaus muss auch der Schließ- und Öffnungsverzug der geschirmten Reed-Kontakte sehr gering sein.

Um einen möglichst genauen Bezug zum Impulsbeging und zum Impulsende zu gewährleisten, ist die Nutzung mehrerer Reed-Kontakte mit und ohne Schirmung entsprechend der vorgeschlagenen Anordnung und Verfahren notwendig. Der Zeitbezug zum Impulsbeginn wird hierbei nur von Reed-Kontakten realisiert, deren beweglichen Kontakte nicht gesättigt sind und deren Schirmung für die Magnetfeldbelastung deutlich unzureichend ist. Das Impulsende wird von Reed-Kontakten bereitgestellt, welche ebenso nicht gesättigt oder mechanisch übererregt sind. Hierzu sind die Reed-Kontakte mit der höchsten Schwelle geeignet, welche noch angesprochen hat.

Die untere Ansprechschwelle für den Langzeitstrom mit wenigen 10 A wird bevorzugt mit einem ungeschirmten Reed-Kontakt mit einer Empfindlichkeit von ca. 2 mT realisiert. Die Schließzeit und der Öffnungsverzug eines solchen Kontaktes liegen bei ca. 10 µs und unterliegen im Arbeitsbereich nur einer geringen Streuung. Für die beabsichtigte Auswertung sind Zeiten von < 50 µs nach hinreichend. Die beweglichen Teile und die Kontaktbeine dieses Reed-Kontaktes mit 2 mT werden jedoch bereits bei wenigen kA gesättigt, wodurch kein exakter Zeitbezug mehr gegeben ist. Es wird daher ein weiterer ungeschirmter Sensor eingesetzt, welcher seine Sättigung erst bei Stromstärken erreicht, welche deutlich oberhalb der Ansprechschwelle des ersten geschirmten Reed-Kontaktes möglichst bereits des zweiten geschirmten Reed-Kontaktes erreicht. Hierzu kann ein gleichartiger Sensor in größerer Distanz oder ein Sensor mit geringer Empfindlichkeit jedoch ebenso geringen Verzugszeiten eingesetzt werden. Für diesen Sensor ist eine Ansprechschwelle von ca. 1 kA hinreichend.

Die weiteren Sensoren mit Schirmung besitzen ebenso eine geringe Empfindlichkeit von kleiner 10 mT oder auch die nur 2 mT des empfindlichsten ungeschirmten Sensors. Die erste Schirmung reduziert die Empfindlichkeit des Sensors um mindestens den Faktor 10, bevorzugt jedoch um einen Faktor größer 50. Dies gewährleistet, dass bei Überlastung des Schirmes die Eigenempfindlichkeit des Sensors nicht einen weiteren Verzug bezüglich des Kontaktverhaltens bewirkt. Bei Schirmungen für höhere Stromschwellen werden deutlich höhere Faktoren verwendet.

Nur die belastungsabhängige Zeitbewertung durch die Kombination des Verhaltens von gezielt ausgewählten Reed-Kontakten der Anordnung mit jeweils unterschiedlicher Schaltschwelle kann einen hinreichend genauen Zeitbezug zu den Einzelimpulsen gewährleisten. Dies sichert die rasche Isolation von Einzelimpulsen in definierten Strombereichen und mit definierter Impulsdauer innerhalb einer Blitzentladung mit zahlreichen einzelnen Impulsvorgängen in dichter Folge. Durch die von der Langzeitstromerfassung unabhängige Impulsbewertung können auch die Einzelimpulse, welchen einen Langzeitstrom überlagern, erfasst und bewertet werden.

Hinsichtlich der Ausbildung der Vorrichtung und der beispielshaften Anordnung von Reed-Kontakten sei auf die diesbezüglichen Ausführungsformen in der auf die Anmelderin zurückgehenden DE 10 2018 107 475 A1 aufmerksam gemacht.

Bekannterweise besteht eine Blitzentladung aus mehreren Teilentladungen mit unterschiedlichen Amplituden und Impulsformen und kann einen Zeitraum von Sekunden umfassen. Die Impulsentladungen werden hierbei teilweise von sogenannten Langzeitströmen mit deutlich geringerer Amplitude, jedoch einer Zeitdauer von mehreren 10 bis 100 Millisekunden überlagert. Die Abfolge von Blitzentladungen innerhalb einer kurzen Zeitdauer belastet eine Fangeinrichtung sowie die daran angeschlossenen Ableitungen. Es ist daher die Kenntnis derartiger Belastungen für eine bedarfsgerechte und rechtzeitige sowie ausreichende Wartung zur Vermeidung von Ausfällen vorteilhaft.

Die erfindungsgemäße Vorrichtung sowie das erfindungsgemäße Verfahren erlaubt eine Bewertung von Entladungsvorgängen. Verfahrensseitig wird eine zeitliche Bewertung und Verknüpfung der Informationen der einzelnen Reed-Kontakte bezüglich der Höhe des Magnetfeldes infolge der einzelnen Entladungsströme genutzt. Die energetische Bewertung erfolgt näherungsweise auf der Basis der technischen Nachbildung der Entladungsanteile über eine fiktive, angenommene Wellenform und deren Energieinhalt bei bestimmter Amplitude. Die Höhe der Amplitude wird über die verschiedenen Schwellwerte der Reed-Kontakte ermittelt. Über die Ermittlung der Zeitdauer mit der jeweiligen Entladung erfolgt die Zuordnung zur Impulsform. Hierbei werden Erstblitz, Folgeblitz und Langzeitstrom unterscheidbar.

Der Erstblitz wird der bekannten Wellenform 10/350 µs nachgebildet. Über die ermittelte Amplitude und die Wellenform kann der Hauptentladung eine bestimmte Energie zugewiesen werden.

Ein kürzerer Folgeblitz besitzt bei gleicher Amplitude nur ca. ein Drittel der Energie eines Erstblitzes.

Der Langzeitstrom wird vereinfacht als Gleichstrom entsprechender Amplitude betrachtet.

Die erfindungsgemäße Lösung geht von der Erfassung der Amplituden und der Zeitdauer der Entladungen mit hinreichender zeitlicher Auflösung bei einer einzelnen Pulsbewertung von < 500 µs aus. Neben der Bewertung von Entladungen kann durch getrennte Erfassung von Langzeit- und Impulsströmen auch eine Bewertung von Impulsen erfolgen, welche einen Langzeitstrom überlagern.

Die erfindungsgemäße Vorrichtung geht auf den nachstehend geschilderten Ansatz zurück.

Die Vorrichtung umfasst mehrere Reed-Kontakte als magnetisch ansprechende Schalter, welche so in der Nähe des elektrischen Leiters angeordnet sind, dass bei einem signifikanten Stromfluss durch den Leiter das resultierende magnetische Feld den Schalter auslöst, wobei für eine Detektion von Stoßstromgrößen und Unterscheidung von Langzeitimpulsströmen und Kurzzeitimpulsströmen eine Vielzahl von Reed-Kontakten in vorgegebenem, unterschiedlichem Abstand vom Leiter angeordnet sind. Darüber hinaus ist eine Auswertelektronik mit Mikrocontroller vorhanden, die das Ansprechen und die Schaltzeiten der jeweiligen Reed-Kontakte ermittelt und eine Wertezuordnung vornimmt.

Mindestens einer der Reed-Kontakte weist eine ferromagnetische Schirmung auf. Mindestens zwei der Reed-Kontakte sind ungeschirmt ausgebildet, wobei die ungeschirmten Reed-Kontakte eine unterschiedliche Empfindlichkeit gegenüber magnetischen Feldstärken besitzen, derart, dass der empfindlichere der ungeschirmten Reed-Kontakte zur Detektion von Langzeitströmen mit geringerer Amplitude und der weniger empfindlichere ungeschirmte Reed-Kontakt zur Detektion von Impulsströmen ausgelegt ist.

Mindestens ein geschirmter Reed-Kontakt ist zur Erfassung von Strömen oberhalb derjenigen ausgelegt, welcher ein Ansprechen der ungeschirmten Reed-Kontakte bewirken.

Der Schwellwert des Ansprechens des geschirmten Reed-Kontaktes ist so bemessen, dass eine Sättigung des ungeschirmten, empfindlicheren Reed-Kontaktes bei dem genannten Schwellwert noch nicht erreicht ist und der unempfindlichere ungeschirmte Reed-Kontakt anspricht und bis zum jeweiligen Stromimpulsende geschlossen bleibt.

Neben den zwei ungeschirmten Reed-Kontakten, welche sich in unterschiedlichem Abstand zum elektrischen Leiter befinden, sind ausgestaltend mindestens vier geschirmte Reed-Kontakte vorgesehen.

Darüber hinaus ist erfindungsgemäß eine Gehäuseanordnung ausgebildet, welche alle funktionsrelevanten elektrischen und elektronischen Komponenten aufnimmt, wobei das Gehäuse Mittel besitzt, um eine, bezogen auf die Ansprechschwellwerte reproduzierbare Befestigung am jeweiligen elektrischen Leiter vorzunehmen.

Das auf die erfindungsgemäße Vorrichtung zurückgreifende Verfahren zur Erfassung und Bewertung von blitzimpulsbedingten Strömen in elektrischen Leitern, die Bestandteil einer Blitzstromableitung sind, oder als eine solche wirken können, nimmt zur Klassifizierung und Unterscheidung des Energiegehaltes der auftretenden Impulsströme eine Erfassung der Amplitude über vorgegebene, jeweils erreichte Ansprechschwellwerte der Reed-Kontakte vor. Die zeitliche Dauer eines Einzelimpulses wird somit am Genauesten durch das Schließ- und Öffnungsverhalten von verschiedenen Sensoren bestimmt. Bei niedrigen Stromstärken wird der Beginn des Impulses durch einen ungeschirmten Sensor bestimmt. Bei hohen Stromstärken und der Sättigung der Kontakte dieser Sensoren wird der Beginn des Impulsvorganges durch das Schließen eines geschirmten Sensors bestimmt, dessen Schirmung deutlich überlastet ist. Die Überlastung der Schirmung eines Sensors sichert das unverzögerte Ansprechen des Reed-Kontaktes und es ist sicher gegeben, wenn ein geschirmter Sensor mit dem nächsthöheren Schwellwert anspricht. Da sowohl die Sättigung der ungeschirmten als auch eine nur verzögerte Überlastung eines Stromes beim grenzwertigen Erreichen der Stromschwelle zu einem verzögerten Ansprechen führen, kann vereinfachend der erstansprechende Sensor aller Sensoren den Beginn der Impulsentladung festlegen.

Das Ende der Pulsentladung wird hingegen durch das Abfallen des jeweils bezogen auf die Ansprechschwelle nächstniedrigeren Reed-Kontaktes ermittelt. Sprechen alle Sensoren einer Anordnung an und die höchste Ansprechschwelle liegt bei 100 kA, wird das Öffnen des Sensors der nächstniedrigen Stromschwelle, zum Beispiel mit 80 kA als Impulsende gewertet. Auf der Basis der ermittelten Amplitude und der jeweiligen Zeitdauer der jeweiligen blitzentladungsbedingten Impulse wird diesem eine spezifische Energie zugeordnet.

Mindestens ein ungeschirmter Reed-Kontakt wird zur Ermittlung kleiner Langzeitströme herangezogen. Der weitere, ungeschirmte Reed-Kontakt wird zur Ermittlung der Dauer von Impulsströmen benutzt.

Der oder die geschirmten Reed-Kontakte dienen zur Erfassung einer Mindest-Impulsstromhöhe.

Das Schließ- und Öffnungsverhalten der Reed-Kontakte wird also ausgewertet und auf der Basis dieser Auswertung erfolgt eine Bestimmung der Anzahl, der jeweiligen Höhe und des jeweiligen Energiegehaltes der Entladungen eines Blitzereignisses.

Die Erfindung soll nachstehend anhand eines Ausführungsbeispieles sowie unter Zuhilfenahme von Figuren näher erläutert werden.

Hierbei zeigen:
Fig. 1 eine beispielhafte Blitzentladung, welche sich über eine Zeitdauer von 1 Sekunde erstreckt, und die neben dem sogenannten Erstblitz Folgeblitze und einen Langzeitstrom umfasst;
Fig. 2 den Verlauf von Entladungen, welche mit einem Langzeitstrom beginnen und wobei kleinere Impulsströme überlagert sind;
Fig. 3a und 3b eine beispielhafte Ausbildung der erfindungsgemäßen Vorrichtung in der Nähe einer Fangstange in seitlicher und frontaler Ansicht;
Fig. 4a und 4b eine Darstellung ähnlich derjenigen nach Fig. 3a und 3b, wobei jedoch zusätzlich eine Gehäuseanordnung und eine prinzipielle Möglichkeit zur Befestigung der Gehäuseanordnung an einer Fangstange dargestellt ist; und
Fig. 5a und 5b einen Programmablaufplan zur Illustration des erfindungsgemäßen Verfahrens.

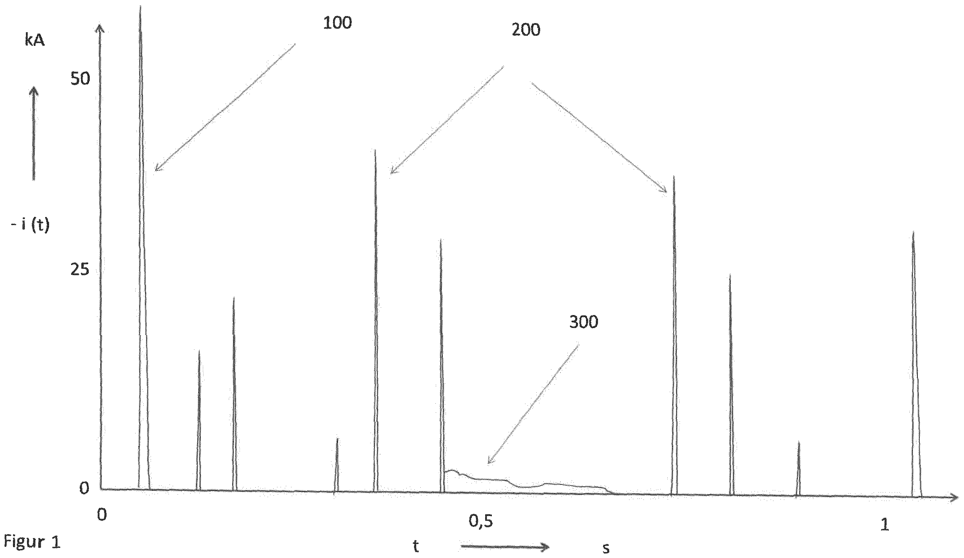

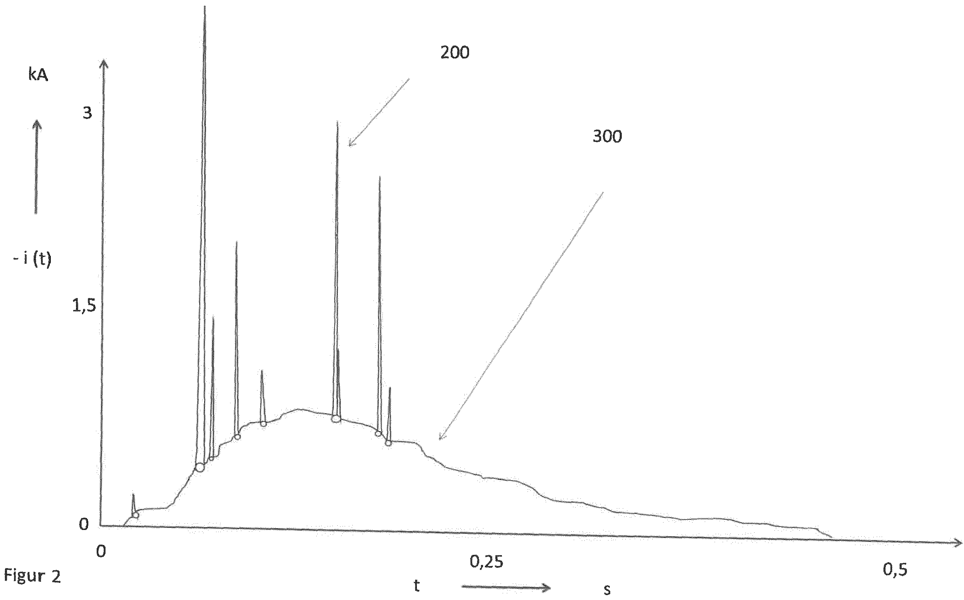

Die Figuren 1 und 2 gehen von einer Darstellung von Blitzströmen i über der Zeit T aus.

Die Figur 1 zeigt beispielhaft eine Blitzentladung, welche sich über eine Zeitdauer von 1 Sekunde erstreckt und die neben dem sogenannten Erstblitz 100 zahlreiche Folgeblitze 200 und einen Langzeitstrom 300 umfasst.

Dem Erstblitz 100 folgen im zeitlichen Abstand von einigen 10 Millisekunden weitere Entladungen, welche häufig den gleichen Entladungskanal nutzen.

An solche Entladungen kann sich ein Langzeitstrom mit einer Höhe von nur einigen 100 Ampere, jedoch über eine Zeitdauer von mehreren 100 Millisekunden anschließen.

Auch sind Entladungsverläufe analog der Darstellung gemäß Figur 2 bekannt, die mit einem Langzeitstrom 300 beginnen und dem bereits kleinere Impulsströme 200 überlagert sind.

Die erfindungsgemäße Vorrichtung zur Bewertung der Stromverläufe bzw. Impulse gemäß den Figuren 1 und 2 geht auf eine Anordnung von Reed-Kontakten zurück.

Reed-Kontakte können aufgrund ihres Funktionsprinzips bei Erreichen einer magnetischen Feldstärke schließen und bei Absinken der Feldstärke unter eine bestimmte Schwelle sich wieder öffnen. Das Schließen und Öffnen dieser Kontakte ist allerdings mit Prellvorgängen verbunden. Aufgrund der hohen Empfindlichkeit gegenüber magnetischen Feldern und auch mechanischen Schockbelastungen kommt es gegebenenfalls auch zu fehlerhaften Schließ- und Öffnungsvorgängen.

Die erfindungsgemäße Lösung sowie das diesbezügliche Verfahren beseitigen diese Probleme für den hier relevanten Einsatzfall und erlauben eine detaillierte Bewertung von Blitzereignissen in einfacher Weise.

Diesbezüglich geht die erfindungsgemäße Vorrichtung von mindestens zwei Reed-Kontakten ohne ferromagnetische Schirmung und mindestens einem, jedoch bevorzugt mehreren geschirmten Reed-Kontakten aus. Die ungeschirmten Reed-Kontakte besitzen eine unterschiedliche Empfindlichkeit gegenüber der magnetischen Feldstärke und detektieren daher unterschiedliche Stromhöhen.

Der empfindlichere Reed-Kontakt ist hier zur Detektion einer Stromschwelle von 50-100 Ampere ausgelegt, um die an sich geringe Amplitude von Langzeitströmen zu erfassen.

Für unterschiedliche Stromhöhen können hier mehrere Sensoren bis ca. 500 Ampere vorgesehen werden. Diesbezüglich können die Sensoren eine unterschiedliche Empfindlichkeit, aber auch eine unterschiedliche Distanz zum stromdurchflossenen Leiter aufweisen.

Der mindestens eine weitere ungeschirmte Sensor besitzt eine Empfindlichkeit von ca. 1 kA. Dieser Stromwert liegt im Allgemeinen oberhalb der Höhe der Langzeitströme und erfasst somit Impulsströme ab einer derartigen Amplitude.

Zur Erfassung von höheren Amplituden der Ströme sind Reed-Kontakte mit einer ferromagnetischen Schirmung vorhanden. Zur Einstellung der Amplitude können verschiedene Materialien und eine baugrößenabhängige Distanz genutzt werden.

Vorgeschlagen ist weiterhin die Verwendung von gleichen, hochempfindlichen Reed-Kontakten in entsprechenden Schirmungen mit gleicher Querschnittsgeometrie aber abgestufter Schirmungslänge.

Durch relativ lange Schirme im Verhältnis zur Baugröße des Sensors lässt sich die Wirkung der Schirmung leicht reduzieren.

Durch die ansonsten gleiche Geometrie kann hier die Fertigung stark vereinfacht werden. Bei ferromagnetischem Material mit hoher Remanenz ist für hohe Stromschwellen eine Mehrfachschirmung mit geringen Wandstärken der inneren Schirmung vorzusehen.

Eine solche Gestaltung der innersten Schirmung mit einer Wandstärke von beispielsweise < 3 mm erlaubt Messgenauigkeiten mit einer Toleranz von < 10 %. Ebenso ist wesentlich, dass bei Schirmmaterialien mit hoher Remanenz hinreichende Abstände zwischen der geschirmten und insbesondere den ungeschirmten Sensoren zur Vermeidung der Beeinflussung dieser untereinander vorzusehen sind. Alternativ können auch Materialien mit geringerer oder ohne Remanenz eingesetzt werden.

Für die zeitliche Auflösung von Einzelvorgängen innerhalb eines Ereignisses und zur Abschätzung des Energieinhaltes der Impulse ist ein Zeitbezug zur Zeitdauer des einzelnen Impulsstromes mit jeweiliger Stromhöhe notwendig. Die Vorrichtung ermöglicht nicht nur die Erfassung der Zeitdauer eines Langzeitstromes, sondern auch die Erfassung des Endes des Entladungsvorganges.

Empfindliche Reed-Kontakte neigen bei hohen magnetischen Feldstärken dazu, nicht zu schließen. Ursache hierfür ist die Sättigung des magnetischen Materials der Kontakte. Bei Sättigung verliert das Material die magnetischen Eigenschaften, wodurch die anziehende Wirkung nicht mehr gegeben ist. Bei Impulsen mit sehr raschem Anstieg der magnetischen Feldstärke erfolgt somit zunächst kein Schließen. Erst bei dem relativ langsamen Abklingen des Impulses und der Reduktion der magnetischen Feldstärke kommt es stark verzögert zum Schließvorgang.

Der zeitliche Bezug geht hier auch ohne die erwähnten Prellvorgänge verloren.

Damit verliert der erste ungeschirmte Reed-Kontakt zur Erfassung der niedrigen Amplituden des Langzeitstromes für die Impulsvorgänge bereits bei einigen Kiloampere oder wenigen 10 Kiloampere jeden Bezug zur realen Impulsdauer.

Die geschirmten Reed-Kontakte hingegen schließen erst, wenn die Sättigung des Schirmmaterials erreicht ist.

Der empfindlichere der ungeschirmten Reed-Kontakte wird daher erfindungsgemäß nur für die Selektion des Langzeitstromes hinsichtlich Schwelle und Zeitverlauf genutzt. Bei höheren Impulsen wird die Schließdauer des unempfindlicheren ungeschirmten Kontaktes zur Bewertung der Impulsdauer herangezogen.

Die Grenze zwischen kleinen und großen Impulsen wird durch das Ansprechen des ersten geschirmten Kontaktes realisiert. Spricht dieser erste Reed-Kontakt an, wird die Schließzeit des unempfindlicheren Kontaktes zur Bewertung der Impulsstromdauer herangezogen.

Der Schwellwert des ersten geschirmten Kontaktes wird so bemessen, dass die Sättigung des ungeschirmten, empfindlicheren Kontaktes bei dieser Stromhöhe noch nicht erreicht ist und ebenso der Reed-Kontakt von einer gegebenenfalls vorhandenen Remanenz der Schirme der anderen Kontakte noch nicht beeinflusst wird.

Der Schwellwert liegt jedoch auch so hoch, dass die magnetische Feldstärke hoch genug ist, dass der unempfindlichere zweite ungeschirmte Reed-Kontakt bereits kurz nach Impulsbeginn anspricht und bis Impulsende geschlossen bleibt. Mögliche verbleibende Prellvorgänge der Kontakte werden analog oder digital gefiltert.

Bei der Verwendung einer Vielzahl von geschirmten Kontakten kann mit geringen Einschränkungen der Genauigkeit der Impulszeitdauerbestimmung ein Reed-Kontakt mit einem sicher überlasteten Schirm zur Festlegung des Impulsbeginnes genutzt werden. Dies ist dann gegeben, wenn der geschirmte Kontakt mit der nächsthöheren Schwelle angesprochen hat. Das Impulsende bestimmt alternativ der Kontakt mit der Schwelle unterhalb des ansprechenden Kontaktes mit dem höchsten Schwellwert.

Auf die vorstehend geschilderte Weise ist eine exakte Ermittlung der Impulsdauer jedes einzelnen Impulses möglich.

Die Impulsvorgänge einer Entladung können nunmehr in den positiven bzw. negativen Erstblitz, den Folgeblitz und den Langzeitstrom unterschieden werden. Die unterschiedlichen Entladungen besitzen unterschiedliche Zeitdauern und Wellenformen. Mit Kenntnis der Amplitude und der Zeitdauer können diesen Entladungsformen somit die spezifischen Energien zugeordnet werden.

Um die einzelnen Entladungen hinsichtlich Zeitdauer, Amplitude und Energie beispielsweise bei einem überlagerten Langzeitstrom zuordnen zu können, ist die Auswertung der Impulsströme zeitnah nach ihrem Abklingen zu beenden und die Bereitschaft für den nächsten Vorgang zu realisieren. Hierzu folgt eine getrennte Auswertung aller Reed-Kontakte. Die Zuordnung der einzelnen Vorgänge zu einer Entladung kann über ein Zeitelement oder auch bei überlagerten Langzeitströmen an dessen Zeitdauer erfolgen.

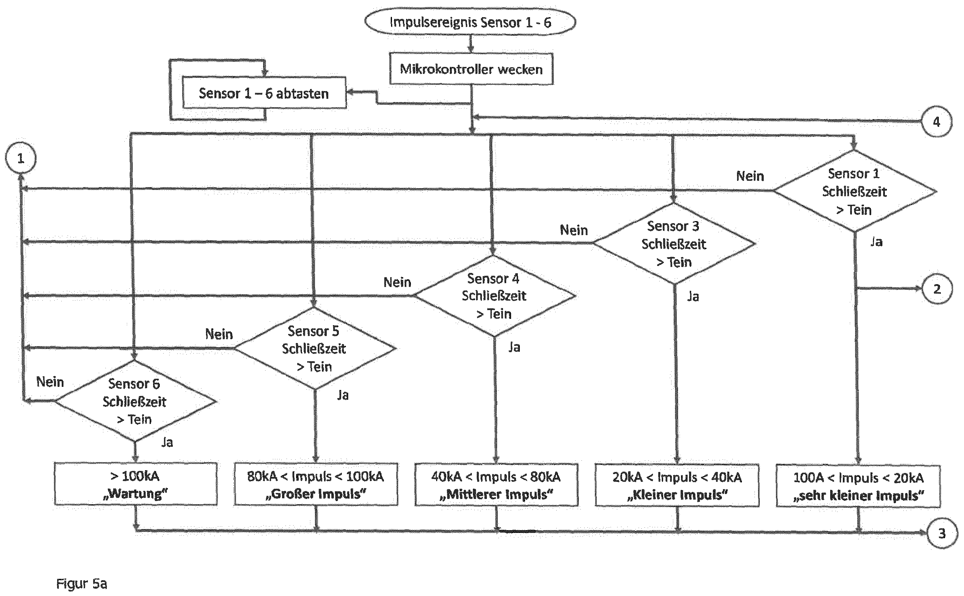

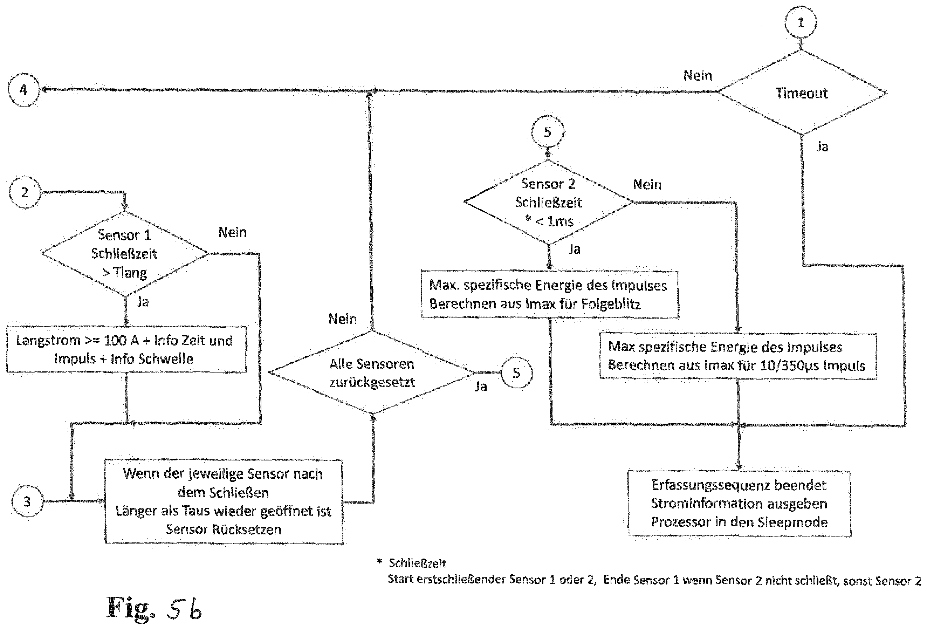

Die erläuterten Maßnahmen zur Erfassung der Zeitdauer einer Einzelentladung, deren Mindeststromhöhe und die Abschätzung des Energieinhaltes lassen sich in dem Ablaufplan nach Fig. 5a und 5b einfach veranschaulichen und beispielsweise mit einem Mikroprozessor unter Zuhilfenahme einer entsprechenden Anordnung bewerten. Dies erlaubt eine detaillierte Bewertung eines gesamten Entladungsereignisses.

Das gezeigte Flussdiagramm nach den Figuren 5a und 5b geht von zwei ungeschirmten Sensoren 1 und 2 mit unterschiedlicher Empfindlichkeit und vier geschirmten Sensoren mit unterschiedlicher Ansprechschwelle aus. Die Auswertung erfolgt bevorzugt direkt mit einem Mikrocontroller, welcher wiederum bevorzugt eine autarke Energieversorgung aufweist bzw. über eine Langzeitbatterie versorgt ist. Die finale Auswertung und Bewertung der Messgrößen kann bei diesbezüglicher Kommunikation auch extern oder durch einen Dritten erfolgen.

Im Flussdiagramm bzw. in dem Ablaufplan gemäß Figuren 5a und 5b werden die einzelnen Reed-Kontakte vereinfachend als Sensoren bezeichnet. Ein ungeschirmter Sensor 1 dient der Erfassung von Strömen ≤ 100 Ampere. Ein ungeschirmter Sensor 2 dient der Erfassung von Strömen > 1000 Ampere. Vier weitere geschirmte Sensoren dienen der Bestimmung von Strömen mit größerem Schwellwert. Der geschirmte Sensor 3 kann beispielsweise für eine Erfassungsschwelle von 20 kA, der Sensor 4 für 40 kA, der Sensor 5 für 80 kA und der Sensor 6 für 100 kA ausgelegt sein. Die Zeiterfassung beginnt, wenn ein Sensor schließt.

Ab diesem Zeitpunkt wird die Schließzeit Tₑᵢₙ der einzelnen Sensoren aufsummiert.

Übersteigt die Schließzeit Tₑᵢₙ einen Schwellwert von > 500 µs, wird der dem Sensor zugeordnete Schwellwert als erfasst gewertet. Die Erfassung der Schließzeit wird fortgesetzt, um die gesamte Schließzeit des Sensors zu ermitteln.

Mit Beginn der Erfassung wird parallel die Zeit Tₐᵤₛ ermittelt, in welcher der Sensor ununterbrochen geöffnet ist bzw. war. Überschreitet Tₐᵤₛ einen Schwellwert von > 500 µs, ist die Erfassung für diesen Sensor beendet und er wird wieder freigegeben.

Die gesamte Erfassungszeit endet, wenn alle Sensoren Tₐᵤₛ überschritten haben.

Am Ende der Erfassungszeit kann die Höhe des Impulses eingegrenzt werden. Der Wert liegt hierbei im Bereich zwischen dem Nennwert des höchsten angesprochenen Sensors und dem nächsthöheren, nicht angesprochenen Sensor. Selbiges erlaubt gemäß Figur 5a und b die Eingruppierung entsprechend der Belastung in sechs Gruppen. Mit dem Sensor 1 ist es damit möglich, einen Langzeitstrom ≥ 100 A bei einer Schließzeit von T_{lang} > 20 ms zu detektieren. Mit Hilfe der weiteren Sensoren können die Impulsströme bis zu > 100 kA unterschieden werden.

Bei entsprechender Dimensionierung des Sensors 2, kann aus dessen Schließzeit auf die Dauer des Impulses geschlossen werden. Ist die Schließzeit des Sensors größer als 1 Millisekunde, kann von einem Stromverlauf entsprechend eines Erstblitzes ausgegangen werden. Liegt die Schließzeit unter diesem Wert, entspricht der Energieinhalt einer solchen Entladung eher einem Folgeblitz. Dadurch ist es möglich, Erstblitze und Folgeblitze zu unterscheiden und entsprechend ihrer Amplitude energetisch zu bewerten.

Die in der Figur 5a und b erläuterten und angegebenen Schwellwerte und Zeiten sind selbstverständlich nur beispielhaft gewählt. Die erfindungsgemäße Lösung kann bezüglich der Anzahl der Schwellwerte für die Amplitude bzw. die Genauigkeit der Zeitschwellwerte erweitert und damit variiert und ergänzt werden.

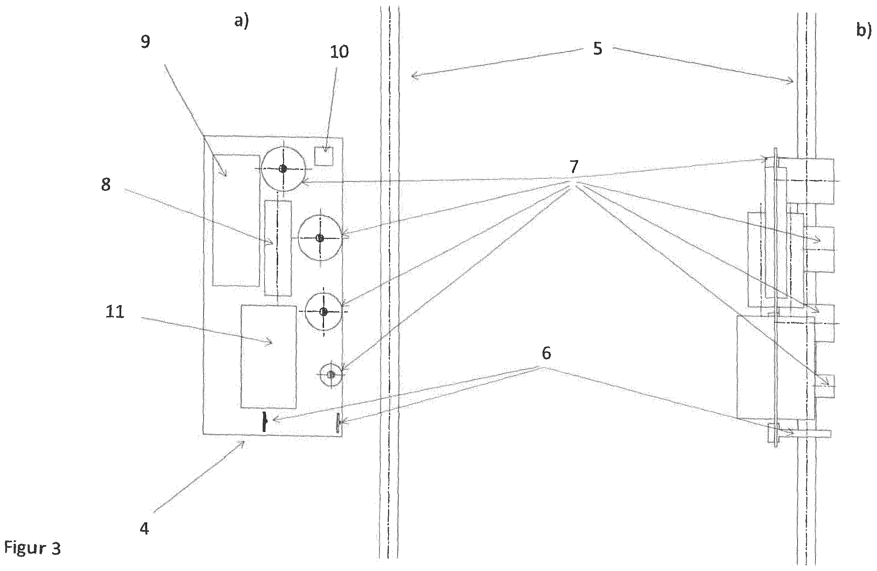

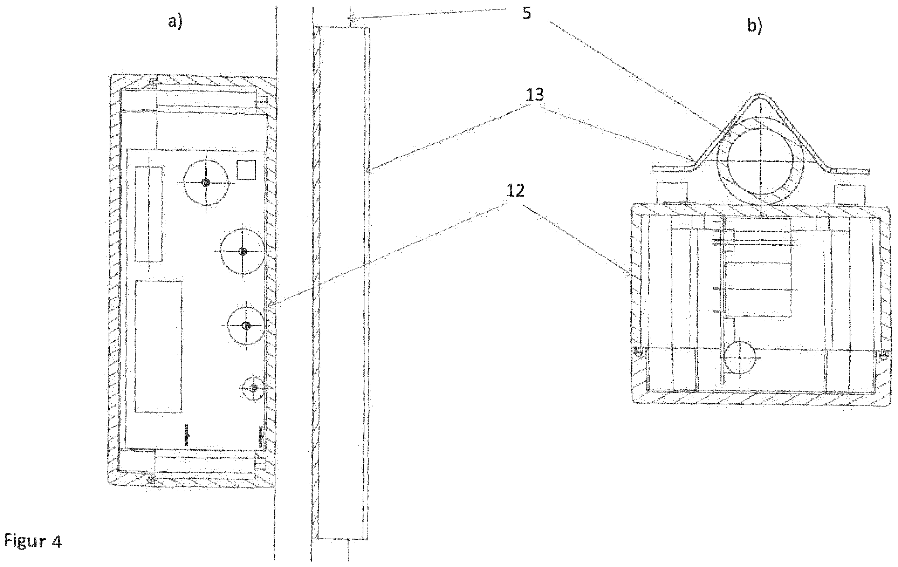

Eine beispielhafte Anordnung der Reed-Kontakte der erfindungsgemäßen Vorrichtung zeigen die Figuren 3a und 3b sowie Figuren 4a und 4b.

Die Figur 3a ist eine seitliche Ansicht und die Figur 3b eine frontale Ansicht einer beispielhaften Vorrichtung. Die Vorrichtung 4 ist mit geeigneten Mitteln in einer definierten Distanz zur Mittelachse einer Fangstange 5 fixiert.

Die eigentliche Fixierung ist in den Figuren 3a und 3b nicht dargestellt.

Die Vorrichtung 4 kann in einem Gehäuse mit separatem Trägerteil, welches die Fixierung einer Leiterplatte, der Schirmungen und der Sensoren übernimmt, untergebracht sein.

Es können jedoch auch die einzelnen Bestandteile in einem gemeinsamen Verguss fixiert und somit mechanisch verbunden werden.

Der Verguss kann hierbei auch die Funktion eines Gehäuses übernehmen.

Gemäß Figur 3a und 3b wird die Vorrichtung 4 beispielsweise auf einem Leiterplattenträger ausgeführt. Die ungeschirmten Sensoren 6 ausgebildet als Reed-Kontakte sind beispielsweise über eine separate Leiterplatte mit einer Hauptplatine verbunden.

Es können aber auch vergossene Reed-Kontakte mit entsprechenden Anschlussleitungen eingesetzt werden. Dieses gilt ebenso für die geschirmten Reed-Kontakte. Die einzelnen Reed-Kontakte befinden sich bevorzugt in der Mittelachse der Schirmungen 7. Die Schirmungen können aus einem oder mehreren Schirmen aus ferromagnetischem Material bestehen.

In der Figur 3a sind vereinfachend nur die äußeren Abmessungen der jeweiligen Schirmung 7 dargestellt.

Der Reed-Kontakt befindet sich angedeutet in der Mitte, dargestellt als schwarzer Punkt im Zentrum der Schirmung.

Die Figur 3b macht deutlich, dass die Schirmungen 7 und der entsprechende Reed-Kontakt jeweils bevorzugt mittig und radial zur Fangstange 5 ausgerichtet sind. Die Empfindlichkeit bzw. der Schwellwert kann hier über die Schirmung 7 und deren Abstand zur Mittelachse der Fangstange 5 eingestellt werden.

Die erfindungsgemäße Vorrichtung umfasst ergänzend eine Energieversorgung, beispielsweise in Form einer Langzeitbatterie 8.

Für die Kommunikation bzw. Datenübertragung kann eine Funkschnittstelle 9 vorgesehen sein. Die weitere Datenbearbeitung und Auswertung erfolgt in der Einheit 10, welche unter anderem einen Mikrocontroller oder Mikroprozessor umfasst, der auch die Steuerung veranlasst.

Die Figuren 4a und 4b in seitlicher und frontaler Ansicht gehen von einer Vorrichtung aus, die beispielhaft in einem Gehäuse 12 zur Montage an einer Fangstange 5 untergebracht ist. Diesbezüglich sind die Figuren 4a und 4b als Längs- und Querschnitt ausgeführt.

Die Befestigung an der Fangstange 5 kann über eine Schellenanordnung 13 vorgenommen werden.

Hierbei ist sicherzustellen, dass der Abstand zur Mittelachse der Fangstange 5, welche in den Figuren als Rohrleiter ausgeführt ist, definiert bleibt.

Die Vorrichtung kann für unterschiedliche Fangstangen und Geometrien ohne Eingriff in das Gehäuse angewendet werden, wenn über entsprechende Befestigungen oder Adapter sichergestellt wird, dass die Distanz der Reed-Kontakte zur Mittelachse der Fangstange 5 bzw. des entsprechenden Leiters gleichbleibt.

Zusätzlich besteht die Möglichkeit, die erfindungsgemäße Vorrichtung innerhalb des Gehäuses 12 verschieblich zu gestalten, um hier eine Reproduzierbarkeit der Schwellwerte des Ansprechens der Reed-Kontakte zu gewährleistet, ohne eine gesonderte spezifische Auslegung vornehmen zu müssen.

Hierdurch kann eine fertige Anschlusseinheit an verschiedene Fangeinrichtungen oder Ableitungen mit verschiedenen Querschnittsformen und Abmessungen problemlos angebunden werden, ohne dass ein separates Einmessen, Justieren oder Kalibrieren erforderlich wird.

## Patentansprüche

1. Vorrichtung zur Erfassung elektrischer Ströme an oder in der Nähe elektrischer Leiter, welche Bestandteil einer Blitzstromableitung, einer Fangstange oder eines elektrisch leitfähigen Bauteils, das nicht für den Blitzschutz vorgesehen ist, über das aber ein Blitzteilstrom fließen kann, sind,
mit mehreren Reed-Kontakten als magnetisch ansprechenden Schaltern, welche so in der Nähe des elektrischen Leiters angeordnet sind, dass bei einem signifikanten Stromfluss, der einer Ansprechschwelle des jeweiligen Reed-Kontakts entspricht, durch den Leiter das resultierende magnetische Feld den jeweiligen Schalter auslöst,
wobei für eine Detektion von Stoßstromgrößen und zur Unterscheidung von Langzeitströmen und Kurzzeitimpulsströmen eine Vielzahl von Reed-Kontakten in vorgegebenen, unterschiedlichen Abständen vom Leiter angeordnet sind,
weiterhin mit einer Auswerteelektronik mit Mikrocontroller, die das Ansprechen und die Schaltzeiten der jeweiligen Reed-Kontakte ermittelt und eine Wertezuordnung vornimmt, **dadurch gekennzeichnet,**
**dass** mindestens einer der Reed-Kontakte eine ferromagnetische Schirmung aufweist und mindestens zwei der Reed-Kontakte ungeschirmt ausgebildet sind,
wobei die ungeschirmten Reed-Kontakte eine unterschiedliche Empfindlichkeit gegenüber der magnetischen Feldstärke besitzen, derart, dass der empfindlichere der ungeschirmten Reed-Kontakte zur Detektion von Langzeitströmen geringerer Amplitude und der weniger empfindlichere ungeschirmte Reed-Kontakt zur Detektion von Impulsströmen ausgeführt ist, wobei ein Langzeitstrom ein Gleichstrom mit einer geringeren Amplitude als ein Impulsstrom ist,
wobei der mindestens eine geschirmte Reed-Kontakt zur Erfassung von Strömen oberhalb derjenigen ausgelegt ist, welche ein Ansprechen der ungeschirmten Reed-Kontakte bewirken, und
wobei der Schwellwert des Ansprechens des geschirmten Reed-Kontaktes so bemessen ist, dass eine Sättigung des ungeschirmten, empfindlicheren Reed-Kontaktes bei dem Schwellwert noch nicht erreicht ist und der unempfindlichere, ungeschirmte Reed-Kontakt anspricht und bis zum jeweiligen Stromimpulsende geschlossen bleibt.

2. Vorrichtung nach Anspruch 1, **dadurch gekennzeichnet, dass** neben den zwei ungeschirmten Reed-Kontakten, welche sich in unterschiedlichem Abstand zum elektrischen Leiter befinden, mindestens vier geschirmte Reed-Kontakte vorgesehen sind.

3. Vorrichtung nach Anspruch 1 oder 2, **dadurch gekennzeichnet, dass** eine Gehäuseanordnung vorgesehen ist, welche alle funktionsrelevanten elektrischen und elektronischen Komponenten aufnimmt, wobei das Gehäuse Mittel aufweist, um eine, bezogen auf die Ansprechschwellwerte reproduzierbare Befestigung am Leiter vorzunehmen.

4. Verfahren zur Erfassung und Bewertung von blitzentladungsbedingten Strömen in elektrischen Leitern, die Bestandteil einer Blitzstromableitung sind oder als eine solche wirken können, mit einer Vorrichtung nach einem der vorangegangenen Ansprüche, **dadurch gekennzeichnet, dass**
zur Klassifizierung und Unterscheidung des Energiegehaltes der auftretenden Impulsströme die Amplitude über vorgegebene, jeweils erreichte Ansprechschwellwerte der Reed-Kontakte und die Zeitdauer der Impulsströme über das Schließen des jeweils erstansprechenden Sensors und das Öffnen des jeweils bezogen auf die Ansprechschwelle nächstniedrigen Reed-Kontaktes ermittelt wird,
wobei auf Basis der ermittelten Amplitude und der jeweiligen Zeitdauer des jeweiligen blitzentladungsbedingten Impulses dessen spezifische Energie zugeordnet wird.

5. Verfahren nach Anspruch 4, **dadurch gekennzeichnet, dass** mindestens ein weiterer ungeschirmter Reed-Kontakt zur Ermittlung der Dauer von Impulsströmen genutzt wird.

6. Verfahren nach einem der Ansprüche 4 oder 5, **dadurch gekennzeichnet, dass** der oder die geschirmten Reed-Kontakte zur Erfassung einer Mindest-Impulsstromhöhe genutzt werden.

7. Verfahren nach einem der Ansprüche 4 bis 6, **dadurch gekennzeichnet, dass** das Schließ- und Öffnungsverhalten der Reed-Kontakte ausgewertet und auf dieser Basis die Anzahl, die jeweilige Höhe und der jeweilige Energiegehalt der Entladungen eines Blitzereignisses bestimmt werden.

## Claims

1. A device for detecting electrical currents on or in the vicinity of electrical conductors that are part of a lightning current arrester, a lightning rod or an electrically conductive component which is not intended for the protection against lightning but over which a lightning partial current can flow,
comprising a plurality of reed contacts as magnetically responsive switches, which are arranged in the vicinity of the electrical conductor such that, in the event of a significant current flow, corresponding to a response threshold of the respective reed contact, through the conductor, the resulting magnetic field trips the respective switch,
a multitude of reed contacts being arranged at predefined, different distances from the conductor for a detection of surge current magnitudes and for the differentiation of long-term currents and short-term pulsed currents,
further comprising an evaluation electronics with a microcontroller, which determines the response and the switching times of the respective reed contacts and performs an assignment of values, **characterized in that**
at least one of the reed contacts includes a ferromagnetic shielding and at least two of the reed contacts are formed to be unshielded,
wherein the unshielded reed contacts have different sensitivities to the magnetic field strength, such that the more sensitive one of the unshielded reed contacts is configured to detect long-term currents of lower amplitude and the less sensitive unshielded reed contact is configured to detect pulsed currents, a long-term current being a direct current having a lower amplitude than a pulsed current,
wherein the at least one shielded reed contact is designed to detect currents above those which cause the unshielded reed contacts to respond, and
wherein the threshold value of the response of the shielded reed contact is dimensioned such that a saturation of the unshielded, more sensitive reed contact is not yet reached at the threshold value and the more insensitive, unshielded reed contact responds and remains closed until the respective current pulse end.

2. The device according to claim 1, **characterized in that** in addition to the two unshielded reed contacts, which are located at different distances from the electrical conductor, at least four shielded reed contacts are provided.

3. The device according to claim 1 or 2, **characterized in that** a housing arrangement is provided which accommodates all functionally relevant electrical and electronic components, the housing including means for performing an attachment to the conductor which is reproducible in terms of the response threshold values.

4. A method of detecting and assessing lightning discharge-induced currents in electrical conductors that are part of a lightning current arrester or can act as such, comprising a device according to any of the preceding claims, **characterized in that**
for classification and differentiation of the energy content of the pulsed currents occurring, the amplitude is determined by means of predefined, respectively reached response threshold values of the reed contacts and the time duration of the pulsed currents is determined by means of the closing of the respectively first-responding sensor and the opening of the respectively next-lower reed contact in terms of the response threshold,
wherein on the basis of the amplitude determined and the respective time duration of the respective lightning discharge-induced pulse, the specific energy thereof is assigned.

5. The method according to claim 4, **characterized in that** at least one further unshielded reed contact is used for determining the duration of pulsed currents.

6. The method according to either of claims 4 or 5, **characterized in that** the shielded reed contact(s) is/are used for detecting a minimum pulsed current level.

7. The method according to any of claims 4 to 6, **characterized in that** the closing and opening behavior of the reed contacts is evaluated and, on this basis, the number, the respective level and the respective energy content of the discharges of a lightning event are determined.

## Revendications

1. Dispositif pour la détection de courants électriques sur ou à proximité de conducteurs électriques qui font partie d'une protection contre les courants de foudre, d'un parafoudre à tige ou d'un élément électriquement conducteur qui n'est pas prévu pour la protection contre la foudre, mais par lequel un courant partiel de foudre peut circuler,
comprenant une pluralité de contacts Reed en tant qu'interrupteurs à réponse magnétique qui sont agencés à proximité du conducteur électrique de sorte que dans le cas d'un flux de courant significatif correspondant à un seuil de réponse du contact Reed correspondant à travers le conducteur, le champ magnétique qui en résulte déclenche l'interrupteur respectif,
une pluralité de contacts Reed étant agencés à différentes distances prédéterminées par rapport au conducteur pour une détection de grandeurs de courant de choc et une distinction de courants de longue durée et de courants pulsés de courte durée,
comprenant en outre une électronique d'évaluation présentant un microcontrôleur qui détermine la réponse et les temps de commutation des contacts Reed respectifs et effectue une attribution des valeurs, **caractérisé en ce que**
au moins l'un des contacts Reed présente un blindage ferromagnétique et au moins deux des contacts Reed sont réalisés non blindés,
les contacts Reed non blindés présentant une sensibilité différente par rapport à l'intensité du champ magnétique, de sorte que le contact le plus sensible des contacts Reed non blindés est réalisé pour la détection de courants de longue durée de plus faible amplitude et le contact Reed non blindé moins sensible est réalisé pour la détection de courants pulsés, un courant de longue durée étant un courant continu d'une amplitude inférieure à celle d'un courant pulsé,
ledit au moins un contact Reed blindé étant réalisé pour la détection de courants supérieurs à ceux qui provoquent la réponse des contacts Reed non blindés, et
la valeur de seuil de la réponse du contact Reed blindé étant calculée de manière à ce qu'une saturation du contact Reed non blindé, plus sensible, n'est pas encore atteinte à la valeur de seuil et le contact Reed non blindé, moins sensible, répond et reste fermé jusqu'à la fin de l'impulsion de courant respective.

2. Dispositif selon la revendication 1, **caractérisé en ce qu'**il est prévu au moins quatre contacts Reed blindés en plus des deux contacts Reed non blindés qui se trouvent à des distances différentes du conducteur électrique.

3. Dispositif selon la revendication 1 ou 2, **caractérisé en ce qu'**il est prévu un agencement de boîtier recevant l'ensemble des composants électriques et électroniques pertinents pour le fonctionnement, le boîtier présentant des moyens pour réaliser une fixation sur le conducteur reproductible par rapport aux valeurs de seuil de réponse.

4. Procédé de détection et d'évaluation de courants dus à la décharge de foudre dans des conducteurs électriques qui font partie d'une protection contre les courants de foudre ou qui peuvent agir en tant que telle, comprenant un dispositif selon l'une des revendications précédentes, **caractérisé en ce que**
pour la classification et la distinction de la teneur énergétique des courants pulsés qui surviennent, l'amplitude est déterminée par des valeurs de seuil de réponse prédéterminées et respectivement atteintes des contacts Reed et la durée des courants pulsés est déterminée par la fermeture du premier capteur respectif qui réagit et par l'ouverture du contact Reed respectif immédiatement inférieur par rapport au seuil de réponse,
l'amplitude déterminée et la durée respective de l'impulsion respective due à la décharge de foudre étant la base pour l'attribution de son énergie spécifique.

5. Procédé selon la revendication 4, **caractérisé en ce qu'**au moins un contact Reed non blindé supplémentaire est utilisé pour la détermination de la durée de courants pulsés.

6. Procédé selon l'une des revendications 4 ou 5, **caractérisé en ce que** le ou les contact(s) Reed blindé(s) est/sont utilisé(s) pour la détection d'un niveau minimum de courant pulsé.

7. Procédé selon l'une des revendications 4 à 6, **caractérisé en ce que** le comportement de fermeture et d'ouverture des contacts Reed est évalué et **en ce que** le niveau respectif et la teneur énergétique respective des décharges d'un événement de foudre sont déterminés sur cette base.
